# EUROPEAN PATENT APPLICATION

(11) **EP 4 773 747 A2**
(43) Date of publication of application: **08.07.2026**
(21) Application number: 26150560.6
(22) Date of filing: 07.01.2026
(51) Int. Cl.: H05K 7/20, G06F 1/20

(54) **TARGETED COOLING**

(30) Priority: 07.01.2025 US 202563742610 P; 02.01.2026 US 202619439249
(71) Applicant: Vertiv Corporation, Westerville, OH 43082 (US)
(72) Inventor: BREUER, Thomas Christopher, Westerville, 43082 (US); KING, Jeremy Ryan, Westerville, 43082 (US); SALEH, Adam Mustafa, Westerville, 43082 (US)
(74) Representative: Ambroz, Simon

(57) **Abstract**

A cooling system can include a cooling loop, a targeted cooling path, a valve for controlling the flow of a first cooling fluid through the targeted cooling path, and a controller for operating the valve. The cooling loop can include a first heat exchanger for transferring heat from a first heat load to the first cooling fluid, a second heat exchanger for rejecting heat from the first cooling fluid, and a prime mover for circulating the first cooling fluid through the cooling loop. The targeted cooling path can include a third heat exchanger for transferring heat from a second heat load to the first cooling fluid.

## Description

### CROSS-REFERENCE TO RELATED APPLICATION(S)

This application claims the benefit of U.S. Provisional Patent Application No. 63/742,610 filed January 7, 2025, and US Nonprovisional Patent Application US 19/439,249 filed January 2, 2026.

### TECHNICAL FIELD

The present disclosure relates generally to cooling systems and more specifically relates to cooling systems for high-density data centers.

### BACKGROUND

As high-density data centers require more power, maintaining low return air temperatures becomes increasingly challenging. As return air temperatures rise, it is important to use components that can withstand the heat. While designing new units with temperature-resistant components is an option, this approach is often costly and time-consuming. A key component impacted by elevated return air temperatures is the electrical panel within the conditioned space. Electrical panels generate heat during operation and typically rely on natural convection for cooling. However, when exposed to hotter return air, an electrical panel's ability to dissipate heat diminishes, increasing the risk of overheating.

### SUMMARY

Applicant has created new and useful devices, systems and methods for cooling systems, such as those used in data centers. In at least one example, a cooling system according to the disclosure can provide precise and/or localized cooling, which is not commonly seen in standard data center cooling configurations. In at least one example, a cooling system according to the disclosure can route water, such as chilled water, or another cooling fluid, to a dedicated coil near one or more key components, such as an electrical panel. In at least one example, a cooling system according to the disclosure can be cost-effective and/or adaptable and enhance the efficiency and lifespan of key components without the need for complete system redesigns, such as by maintaining those components at a desired temperature even in the face of increasing thermal demands of modern high-density data centers.

In at least one example, a cooling system according to the disclosure can include a cooling loop, a targeted cooling path, a valve for controlling the flow of cooling fluid through the targeted cooling path, a controller for operating the valve, or any combination thereof. In at least one example, the cooling loop can include a first heat exchanger for transferring heat from a first heat load to a first cooling fluid, a second heat exchanger for rejecting heat from the first cooling fluid, a prime mover for circulating the first cooling fluid through the cooling loop, or any combination thereof. In at least one example, the targeted cooling path can include a third heat exchanger for transferring heat from a second heat load to the first cooling fluid.

In at least one example, the targeted cooling path can be plumbed in parallel with at least a portion of the cooling loop. In at least one example, at least a portion of the first cooling fluid can flow through the targeted cooling path, bypassing at least a portion of the cooling loop. In at least one example, the targeted cooling path and/or the third heat exchanger can be plumbed in parallel with the first heat exchanger and at least a portion of the first cooling fluid can flow through the targeted cooling path and/or the third heat exchanger, bypassing the first heat exchanger.

In at least one example, the first cooling fluid can be a single-phase fluid, such as water or a water/glycol mixture. In at least one example, the first cooling fluid can be a two-phase fluid, such as a refrigerant. In at least one example, the first cooling fluid can include water, such as chilled water, and/or the prime mover can be a pump. In at least one example, the first cooling fluid can be a two-phase refrigerant and/or the prime mover can be a compressor.

In at least one example, the first cooling fluid coming from the first heat exchanger and the third heat exchanger can combine before entering the second heat exchanger. In at least one example, the second heat exchanger can reject heat from the first heat load and the second heat load. In at least one example, the first cooling fluid coming from the second heat exchanger can split before entering the first heat exchanger, the prime mover, the third heat exchanger, or any combination thereof. In at least one example, the prime mover can circulate the first cooling fluid through the cooling loop and the targeted cooling path. In at least one example, the prime mover can circulate the first cooling fluid through the cooling loop and another the prime mover can circulate the first cooling fluid through the targeted cooling path.

In at least one example, the first heat load can be computing equipment, such as servers, networking devices, data storage devices, other information technology (IT) devices, or any combination thereof. In at least one example, the second heat load can be an electrical power supply component configured to provide electrical power to the computing equipment. **In** at least one example, the electrical power supply component can be an electrical power panel configured to provide electrical power to the first heat load, such as the computing equipment. In at least one example, the electrical power panel can include a plurality of breakers configured to selectively provide electrical power to the first heat load, such as the computing equipment.

In at least one example, the first heat exchanger can be a fluid-to-fluid heat exchanger for transferring heat from a second cooling fluid to the first cooling fluid. In at least one example, the second cooling fluid can extract heat from the first heat load, such as the computing equipment. In at least one example, one or more cold plates, direct-to-chip heat exchangers, other heat exchangers, or any combination thereof can transfer heat from the first heat load(s) to the second cooling fluid.

In at least one example, the first heat exchanger can be a fluid-to-air heat exchanger. In at least one example, a fan can induce airflow, such as along a first airflow path, through the first heat exchanger to transfer heat from the first heat load, such as the computing equipment, to the first cooling fluid. In at least one example, the first heat load, such as the computing equipment, can be in the first airflow path.

In at least one example, the third heat exchanger can be a fluid-to-air heat exchanger. In at least one example, a fan can induce airflow, such as along a second airflow path, through the third heat exchanger to transfer heat from the second heat load, such as an electrical power supply component, to the first cooling fluid. In at least one example, the second heat load, such as an electrical power supply component, can be in the first airflow path and/or the second airflow path. In at least one example, the first heat exchanger can transfer heat from the first heat load and the second heat load to the first cooling fluid.

In at least one example, the valve can be plumbed in the cooling loop, the targeted cooling path, or any combination thereof. In at least one example, the valve can be plumbed in only the targeted cooling path and/or can be a simple on/off valve. In at least one example, the valve can be a diverter valve and/or can control flow through the cooling loop, the targeted cooling path, or any combination thereof.

In at least one example, the controller can monitor a temperature associated with the second heat load and/or control the flow of the first cooling fluid through the targeted cooling path, using the valve. In at least one example, the controller can control the flow of the first cooling fluid through the targeted cooling path based at least in part on temperature.

### BRIEF DESCRIPTION OF THE DRAWINGS

FIG. 1 is a partial schematic view of one of many examples of a cooling system according to the disclosure.
FIG. 2 is a partial schematic view of another one of many examples of a cooling system according to the disclosure.
FIG. 3 is a partial schematic view of yet another one of many examples of a cooling system according to the disclosure.
FIG. 4 is a partial schematic view of still another one of many examples of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for cooling systems, such as those used in data centers. In at least one example, a cooling system according to the disclosure can provide precise and/or localized cooling, which is not commonly seen in standard data center cooling configurations. In at least one example, a cooling system according to the disclosure can route water, such as chilled water, or another cooling fluid, to a dedicated coil near one or more key components, such as an electrical panel. In at least one example, a cooling system according to the disclosure can be cost-effective and/or adaptable and enhance the efficiency and lifespan of key components without the need for complete system redesigns, such as by maintaining those components at a desired temperature even in the face of increasing thermal demands of modern high-density data centers.

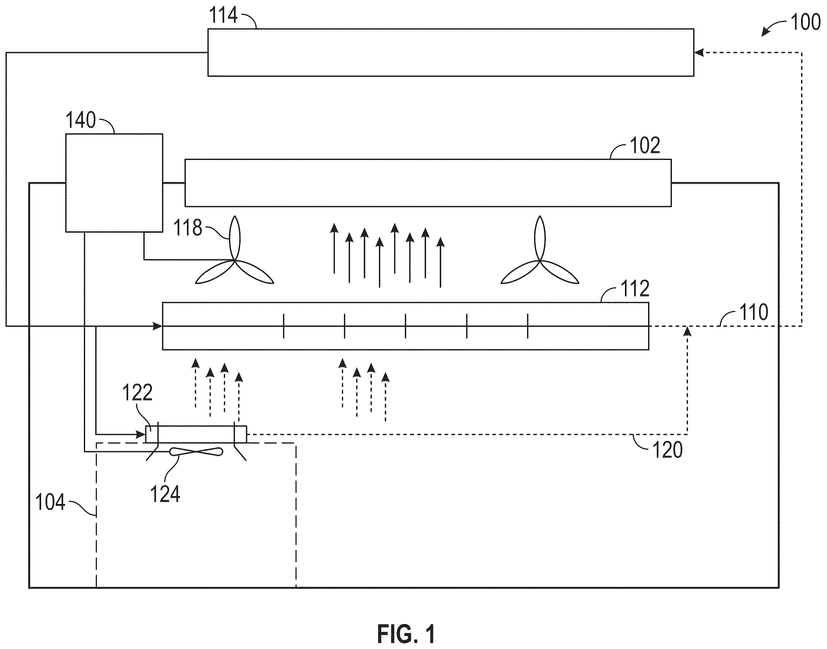

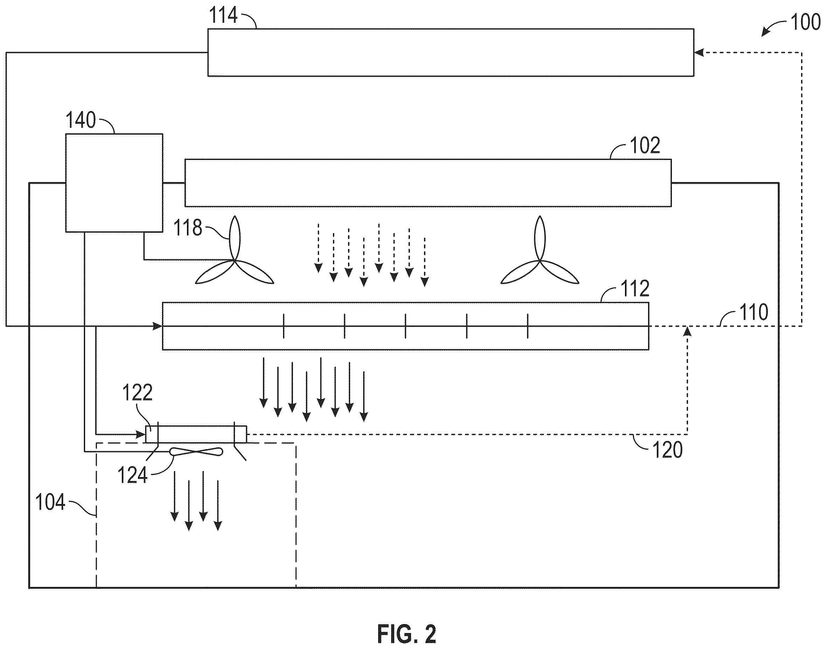

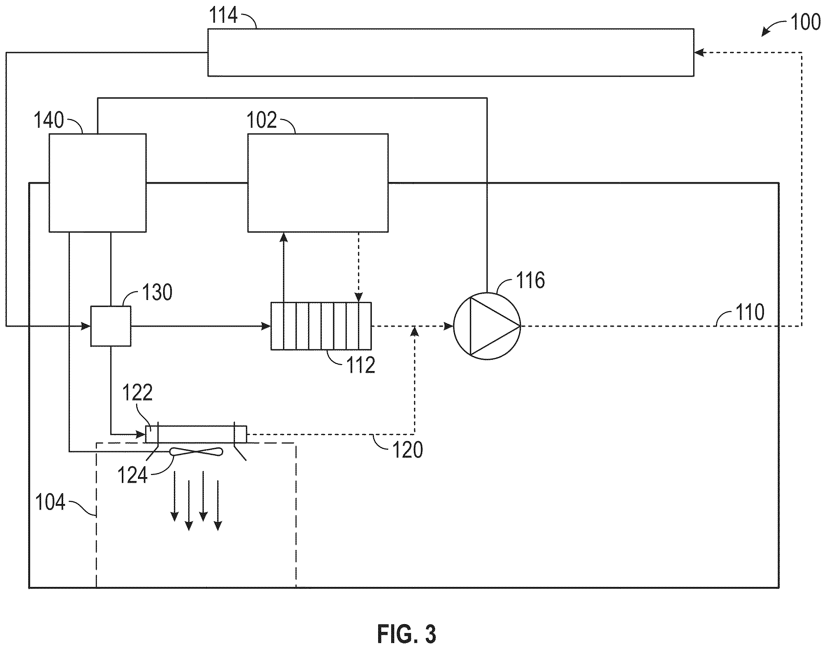

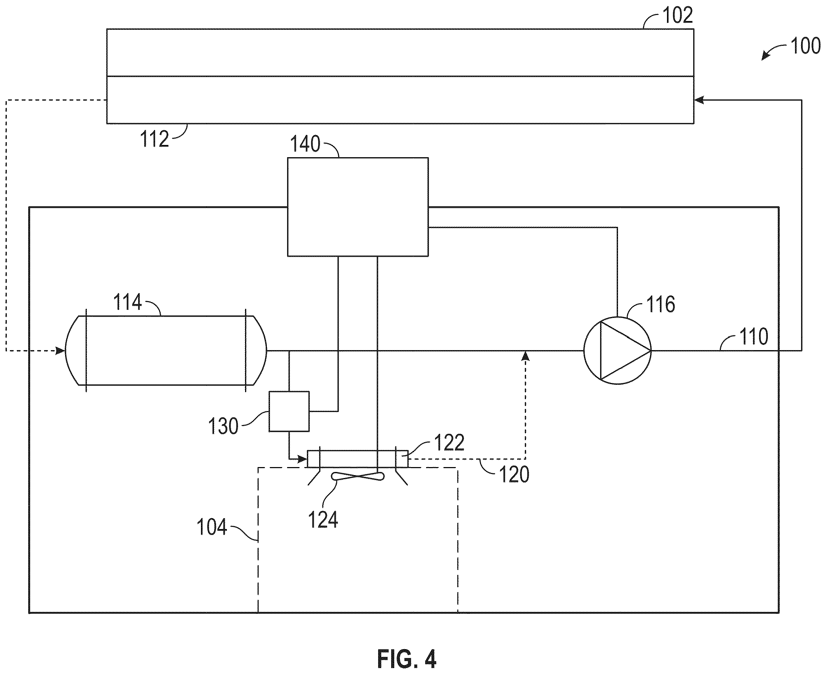

FIG. 1 is a partial schematic view of one of many examples of a cooling system according to the disclosure. FIG. 2 is a partial schematic view of another one of many examples of a cooling system according to the disclosure. FIG. 3 is a partial schematic view of yet another one of many examples of a cooling system according to the disclosure. FIG. 4 is a partial schematic view of still another one of many examples of a cooling system according to the disclosure. FIGS. 1-4 are described in conjunction with one another.

In at least one example, a cooling system 100 according to the disclosure can include one or more cooling loops 110, one or more targeted cooling paths 120, one or more valves 130 for controlling the flow of cooling fluid through the targeted cooling path(s), one or more controller 140 for operating the valve(s), or any combination thereof. In at least one example, a cooling loop 110 can include one or more primary heat exchangers 112 for transferring heat from one or more primary heat loads 102 to a cooling fluid, one or more secondary heat exchangers 114 for rejecting heat from the cooling fluid, one or more prime movers 116 for circulating the cooling fluid through the cooling loop 110, or any combination thereof. In at least one example, the targeted cooling path 120 can include one or more tertiary heat exchangers 122 for transferring heat from one or more secondary heat loads 104 to the cooling fluid, which can be the same as the cooling fluid flowing through one or more of the other heat exchangers 112, 114.

In at least one example, the targeted cooling path 120 can be plumbed in parallel with at least a portion of the cooling loop 110, such as a first, second or other portion. **In** at least one example, a portion of the cooling fluid can flow through the targeted cooling path 120, bypassing at least a portion of the cooling loop 110, such as a first, second or other portion. In at least one example, the tertiary heat exchanger 122 and/or another portion of the targeted cooling path 120 can be plumbed in parallel with the primary heat exchanger 112 and a portion of the cooling fluid can flow through the targeted cooling path 120, bypassing the primary heat exchanger 112.

In at least one example, the cooling fluid can be a single-phase fluid, such as water or a water/glycol mixture. In at least one example, the cooling fluid can be a two-phase fluid, such as a refrigerant. In at least one example, the cooling fluid can include water, such as chilled water, and/or the prime mover 116 can be or include one or more pumps. In at least one example, the cooling fluid can be a two-phase refrigerant and/or the prime mover 116 can be or include one or more compressors.

In at least one example, the cooling fluid coming from the primary heat exchanger 112 and the tertiary heat exchanger 122 can combine before entering the secondary heat exchanger 114 and/or the prime mover 116. In at least one example, the cooling fluid coming from the primary heat exchanger 112 and the tertiary heat exchanger 122 can combine between the secondary heat exchanger 114 and the prime mover 116. In at least one example, the secondary heat exchanger 114 can reject heat from the primary heat load 102 and the secondary heat load 104. In at least one example, the cooling fluid coming from the secondary heat exchanger 114 can split before entering the primary heat exchanger 112, the prime mover 116, the tertiary heat exchanger 122, or any combination thereof. In at least one example, the prime mover 116 can circulate the cooling fluid through the cooling loop 110 and the targeted cooling path 120. In at least one example, the prime mover 116 can circulate the cooling fluid through the cooling loop 110 and another the prime mover 116 can circulate the cooling fluid through the targeted cooling path 120. In at least one example, each prime mover 116 can independently control flow of the cooling fluid through the cooling loop 110 and/or the targeted cooling path 120.

In at least one example, the primary heat load 102 can be or include computing equipment, such as servers, networking devices, data storage devices, other information technology (IT) devices, or any combination thereof. In at least one example, the secondary heat load 104 can be or include an electrical power supply component configured to provide electrical power to the computing equipment. In at least one example, the electrical power supply component can be an electrical power panel configured to provide electrical power to the primary heat load 102, such as the computing equipment. In at least one example, the electrical power panel can include one or more breakers and/or one or more other electrical power supply components configured to selectively provide electrical power to the primary heat load 102, such as the computing equipment.

In at least one example, the primary heat load 102, the secondary heat load 104, the primary heat exchanger 112, the prime mover 116, the tertiary heat exchanger 122, or any combination thereof can be at least partially disposed in a cabinet or other enclosure, such as those used in data centers. In at least one example, the primary heat load 102, the secondary heat load 104, the primary heat exchanger 112, the prime mover 116, the tertiary heat exchanger 122, or any combination thereof can be disposed in the same cabinet. In at least one example, air can circulate, in the cabinet or other enclosure, past and/or through the primary heat load 102, the secondary heat load 104, the primary heat exchanger 112, the prime mover 116, the tertiary heat exchanger 122, or any combination thereof. In at least one example, air, such as that circulating in the cabinet or other enclosure, can draw heat from the primary heat load 102, the secondary heat load 104, the prime mover 116, or any combination thereof, and transfer that heat to the cooling fluid through the primary heat exchanger 112 and/or the tertiary heat exchanger 122.

In at least one example, the primary heat load 102, the secondary heat load 104, the tertiary heat exchanger 122, or any combination thereof can be at least partially disposed in an enclosure, such as a cabinet. In at least one example, the primary heat exchanger 112 and/or the prime mover 116, can be at least partially disposed outside the cabinet and cool a room, such as of a data center, in which the cabinet is disposed. In at least one example, the primary heat load 102, the secondary heat load 104, the primary heat exchanger 112, the prime mover 116, the tertiary heat exchanger 122, or any combination thereof can be at least partially disposed in a room, such as of a data center, and/or the secondary heat exchanger 114 and/or the prime mover 116 can be at least partially disposed outside the room.

In at least one example, the secondary heat exchanger 114 can be at least partially disposed outside the cabinet, outside the room, outside the data center, otherwise configured to transfer heat to an external environment and/or another cooling fluid, or any combination thereof. In at least one example, the secondary heat exchanger 114 can be or include one or more fluid-to-fluid heat exchangers, one or more fluid-to-air heat exchangers, one or more condensers, shell- and-tube heat exchangers, one or more chillers, one or more other heat exchangers, or any combination thereof.

In at least one example, the primary heat exchanger 112 can be a fluid-to-fluid heat exchanger, such as a brazed plate heat exchanger (BPHE), for transferring heat to the cooling fluid from a second cooling fluid. In at least one example, the second cooling fluid can extract heat from the primary heat load 102, such as in a second cooling loop. In at least one example, one or more prime movers 116 can control flow of, or otherwise circulate, the second cooling fluid through the second loop. In at least one example, one or more cold plates, direct-to-chip heat exchangers, other heat exchangers, or any combination thereof can transfer heat from the primary heat load 102(s) to the second cooling fluid.

In at least one example, the primary heat exchanger 112 can be a fluid-to-air heat exchanger. In at least one example, one or more fans 118 can induce airflow, such as along a first airflow path, through the primary heat exchanger 112 to transfer heat from the primary heat load 102, such as the computing equipment, to the cooling fluid. In at least one example, the primary heat load 102, such as the computing equipment, can be in the first airflow path.

In at least one example, the tertiary heat exchanger 122 can be a fluid-to-air heat exchanger. In at least one example, a fan 124 can induce airflow, such as along a second airflow path, through the tertiary heat exchanger 122 to transfer heat from the secondary heat load 104, such as an electrical power supply component, to the cooling fluid. In at least one example, the secondary heat load 104, such as an electrical power supply component, can be in the first airflow path and/or the second airflow path. In at least one example, the primary heat exchanger 112 can transfer heat from the primary heat load 102 and the secondary heat load 104 to the cooling fluid.

In at least one example, the valve 130 can be plumbed in the cooling loop 110, the targeted cooling path 120, or any combination thereof. In at least one example, the valve 130 can control flow of the cooling fluid through the cooling loop 110, the targeted cooling path 120, or any combination thereof. In at least one example, the valve 130 can be plumbed in only the targeted cooling path 120 and/or can be a simple on/off valve. In at least one example, the valve 130 can be a diverter valve and/or can control flow through at least a portion of the cooling loop 110, the targeted cooling path 120, or any combination thereof. In at least one example, the valve 130 can be or include multiple valves, such as one or more valves for controlling flow of the cooling fluid through the cooling loop 110 and/or one or more valves for controlling flow of the cooling fluid through the targeted cooling path 120. In at least one example, one or more valves 130 can be or include an electronically or electrically controlled valve.

In at least one example, the controller 140 can monitor a temperature associated with the secondary heat load 104 and/or control, using the valve 130, the flow of the cooling fluid through the cooling loop 110, the targeted cooling path 120, or any combination thereof. In at least one example, the controller 130 can control the flow of the cooling fluid through the targeted cooling path 120 based at least in part on one or more temperatures, such as the monitored temperature associated with the secondary heat load 104 and/or one or more other temperatures. In at least one example, the controller 130 can control other components of the system 100, such as the prime mover(s) 116, any or all of the fans 118, 124. In at least one example, the controller 130 can include one or more user interfaces, such as to allow reception of a setpoint for the temperature. In at least one example, the controller 130 can control the prime mover(s) 116, any or all of the fans 118, 124, the valve 130, or any combination thereof to maintain the temperature at or near the setpoint. In at least one example, the controller 130 can control the prime mover(s) 116, any or all of the fans 118, 124, the valve 130, or any combination thereof to maintain a temperature associated with the primary heat load 102.

In at least one example, the tertiary heat exchanger 122 can target one or more specific components and/or one or more specific areas of an enclosure, such as a cabinet or a room, while the primary heat exchanger 112 can target one or more other components and/or the enclosure more generally. In at least one example, a cooling system 100 according to the disclosure can provide proper cooling to the primary heat load 102, such as the computing equipment, while providing additional, targeted, and/or localized cooling to one or more secondary heat loads 104, such as electrical power supply components and/or other key components. In at least one example, the controller 130 can control an amount of the first cooling fluid that is diverted to the targeted cooling path 120 and/or the tertiary heat exchanger 122 and can precisely provide the desired cooling to the secondary heat load(s) 104.

As will be appreciated by those skilled in the art having the benefits of the present disclosure, aspects of one or more examples of the disclosure can be embodied as a system, method or computer program product. Accordingly, aspects of the present examples can take the form of an entirely hardware example, an entirely software example (including firmware, resident software, micro-code, etc.) or an example combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to examples of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one example, a cooling system according to the disclosure can include a cooling loop, a targeted cooling path, a valve for controlling the flow of cooling fluid through the targeted cooling path, a controller for operating the valve, or any combination thereof. In at least one example, the cooling loop can include a first heat exchanger for transferring heat from a first heat load to a first cooling fluid, a second heat exchanger for rejecting heat from the first cooling fluid, a prime mover for circulating the first cooling fluid through the cooling loop, or any combination thereof. In at least one example, the targeted cooling path can include a third heat exchanger for transferring heat from a second heat load to the first cooling fluid.

In at least one example, the targeted cooling path can be plumbed in parallel with at least a portion of the cooling loop, such as a first, second or other portion. In at least one example, at least a portion of the first cooling fluid can flow through the targeted cooling path, bypassing at least a portion of the cooling loop, such as a first, second or other portion. In at least one example, the targeted cooling path and/or the third heat exchanger can be plumbed in parallel with the first heat exchanger and at least a portion of the first cooling fluid can flow through the targeted cooling path and/or the third heat exchanger, bypassing the first heat exchanger.

In at least one example, the first cooling fluid can be a single-phase fluid, such as water or a water/glycol mixture. In at least one example, the first cooling fluid can be a two-phase fluid, such as a refrigerant. In at least one example, the first cooling fluid can include water, such as chilled water, and/or the prime mover can be a pump. In at least one example, the first cooling fluid can be a two-phase refrigerant and/or the prime mover can be a compressor.

In at least one example, the first cooling fluid coming from the first heat exchanger and the third heat exchanger can combine before entering the second heat exchanger. In at least one example, the second heat exchanger can reject heat from the first heat load and the second heat load. In at least one example, the first cooling fluid coming from the second heat exchanger can split before entering the first heat exchanger, the prime mover, the third heat exchanger, or any combination thereof. In at least one example, the prime mover can circulate the first cooling fluid through the cooling loop and the targeted cooling path. In at least one example, the prime mover can circulate the first cooling fluid through the cooling loop and another the prime mover can circulate the first cooling fluid through the targeted cooling path.

In at least one example, the first heat load can be computing equipment, such as servers, networking devices, data storage devices, other IT devices, or any combination thereof. In at least one example, the second heat load can be an electrical power supply component configured to provide electrical power to the computing equipment. In at least one example, the electrical power supply component can be an electrical power panel configured to provide electrical power to the first heat load, such as the computing equipment. In at least one example, the electrical power panel can include a plurality of breakers configured to selectively provide electrical power to the first heat load, such as the computing equipment.

In at least one example, the first heat exchanger can be a fluid-to-fluid heat exchanger for transferring heat from a second cooling fluid to the first cooling fluid. In at least one example, the second cooling fluid can extract heat from the first heat load, such as the computing equipment. In at least one example, one or more cold plates, direct-to-chip heat exchangers, other heat exchangers, or any combination thereof can transfer heat from the first heat load(s) to the second cooling fluid.

In at least one example, the first heat exchanger can be a fluid-to-air heat exchanger. In at least one example, a fan can induce airflow, such as along a first airflow path, through the first heat exchanger to transfer heat from the first heat load, such as the computing equipment, to the first cooling fluid. In at least one example, the first heat load, such as the computing equipment, can be in the first airflow path.

In at least one example, the third heat exchanger can be a fluid-to-air heat exchanger. In at least one example, a fan can induce airflow, such as along a second airflow path, through the third heat exchanger to transfer heat from the second heat load, such as an electrical power supply component, to the first cooling fluid. In at least one example, the second heat load, such as an electrical power supply component, can be in the first airflow path and/or the second airflow path. In at least one example, the first heat exchanger can transfer heat from the first heat load and the second heat load to the first cooling fluid.

In at least one example, the valve can be plumbed in the cooling loop, the targeted cooling path, or any combination thereof. In at least one example, the valve can be plumbed in only the targeted cooling path and/or be a simple on/off valve. In at least one example, the valve can be a diverter valve and/or control flow through the cooling loop, the targeted cooling path, or any combination thereof.

In at least one example, the controller can monitor a temperature associated with the second heat load and/or control the flow of the first cooling fluid through the targeted cooling path, using the valve. In at least one example, the controller can control the flow of the first cooling fluid through the targeted cooling path based at least in part on temperature.

The devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

Disclosed herein are the following clauses:
1. A cooling system comprising: a cooling loop including: a first heat exchanger configured to transfer heat from a first heat load to a first cooling fluid; a second heat exchanger configured to reject heat from the first cooling fluid; and a prime mover configured to circulate the first cooling fluid through the cooling loop; and a targeted cooling path including: a third heat exchanger configured to transfer heat from a second heat load to the first cooling fluid; wherein the targeted cooling path is plumbed in parallel with a first portion of the cooling loop; and wherein the cooling system if configured to route at least a portion of the first cooling fluid through the targeted cooling path, bypassing the first portion of the cooling loop.
2. The cooling system as set forth in clause 1, wherein the first heat load includes computing equipment and the second heat load includes an electrical power supply component configured to provide electrical power to the computing equipment.
3. The cooling system as set forth in clause 1, wherein the second heat exchanger is configured to reject heat from the first heat load and the second heat load.
4. The cooling system as set forth in clause 1, wherein the prime mover is configured to circulate the first cooling fluid through the cooling loop and the targeted cooling path.
5. The cooling system as set forth in clause 1, wherein the targeted cooling path is plumbed in parallel with the first heat exchanger.
6. The cooling system as set forth in clause 1, wherein the third heat exchanger is plumbed in parallel with the first heat exchanger.
7. The cooling system as set forth in clause 1, wherein the first heat exchanger is a fluid-to-fluid heat exchanger configured to transfer heat from a second cooling fluid to the first cooling fluid; and wherein the second cooling fluid is configured to extract heat from computing equipment.
8. The cooling system as set forth in clause 1, wherein the first heat load is computing equipment; wherein the first heat exchanger is a fluid-to-air heat exchanger; and further comprising a first fan configured to induce airflow along a first airflow path through the first heat exchanger to transfer heat from the computing equipment to the first cooling fluid.
9. The cooling system as set forth in clause 8, wherein the second heat load is an electrical power supply component configured to provide electrical power to the computing equipment; wherein the third heat exchanger is a fluid-to-air heat exchanger; and further comprising a second fan configured to induce airflow along a second airflow path through the third heat exchanger to transfer heat from the electrical power supply component to the first cooling fluid.
10. The cooling system as set forth in clause 9, wherein the computing equipment is disposed in the first airflow path.
11. The cooling system as set forth in clause 10, wherein the electrical power supply component is disposed in the second airflow path.
12. The cooling system as set forth in clause 10, wherein the electrical power supply component is disposed in the first airflow path and the second airflow path.
13. The cooling system as set forth in clause 12, wherein the first heat exchanger is configured to transfer heat from the first heat load and the second heat load to the first cooling fluid.
14. The cooling system as set forth in clause 1, wherein the first heat load is computing equipment and the second heat load is an electrical power supply component configured to provide electrical power to the computing equipment; wherein the third heat exchanger is a fluid-to-air heat exchanger; and further comprising a fan configured to induce airflow through the third heat exchanger to transfer heat from the electrical power supply component to the first cooling fluid.
15. The cooling system as set forth in clause 1, wherein the first cooling fluid comprises water and the prime mover is a pump.
16. The cooling system as set forth in clause 1, wherein the first cooling fluid is a two-phase refrigerant and the prime mover is a compressor.
17. The cooling system as set forth in clause 1, further comprising a valve configured to control flow of the first cooling fluid through the targeted cooling path.
18. The cooling system as set forth in clause 17, further comprising a controller configured to monitor a temperature associated with the second heat load and operate the valve to control the flow of the first cooling fluid through the targeted cooling path based at least in part on the temperature.
19. The cooling system as set forth in clause 1, wherein the second heat load comprises an electrical power panel configured to provide electrical power to the first heat load.
20. The cooling system as set forth in clause 19, wherein the electrical power panel comprises a plurality of breakers configured to selectively provide electrical power to the first heat load.

Described herein are also the following items:
1. A cooling system comprising:
   a cooling loop including:
      a first heat exchanger configured to transfer heat from a first heat load to a first cooling fluid;
      a second heat exchanger configured to reject heat from the first cooling fluid; and
      a prime mover configured to circulate the first cooling fluid through the cooling loop; and
   a targeted cooling path including:
      a third heat exchanger configured to transfer heat from a second heat load to the first cooling fluid;
   wherein the targeted cooling path is plumbed in parallel with a first portion of the cooling loop; and
   wherein the cooling system if configured to route at least a portion of the first cooling fluid through the targeted cooling path, bypassing the first portion of the cooling loop.
2. The cooling system as set forth in item 1, wherein the first heat load includes computing equipment and the second heat load includes an electrical power supply component configured to provide electrical power to the computing equipment.
3. The cooling system as set forth in any preceding item, wherein the second heat exchanger is configured to reject heat from the first heat load and the second heat load.
4. The cooling system as set forth in any preceding item, wherein the prime mover is configured to circulate the first cooling fluid through the cooling loop and the targeted cooling path.
5. The cooling system as set forth in any preceding item, wherein the targeted cooling path is plumbed in parallel with the first heat exchanger.
6. The cooling system as set forth in any preceding item, wherein the third heat exchanger is plumbed in parallel with the first heat exchanger.
7. The cooling system as set forth in any preceding item, wherein the first heat exchanger is a fluid-to-fluid heat exchanger configured to transfer heat from a second cooling fluid to the first cooling fluid; and wherein the second cooling fluid is configured to extract heat from computing equipment.
8. The cooling system as set forth in any preceding item, wherein the first heat load is computing equipment; wherein the first heat exchanger is a fluid-to-air heat exchanger; and further comprising a first fan configured to induce airflow along a first airflow path through the first heat exchanger to transfer heat from the computing equipment to the first cooling fluid.
9. The cooling system as set forth in item 8, wherein the second heat load is an electrical power supply component configured to provide electrical power to the computing equipment; wherein the third heat exchanger is a fluid-to-air heat exchanger; and further comprising a second fan configured to induce airflow along a second airflow path through the third heat exchanger to transfer heat from the electrical power supply component to the first cooling fluid;
   and optionally, wherein the computing equipment is disposed in the first airflow path; and optionally, wherein the electrical power supply component is disposed in the second airflow path;
   and optionally, wherein the electrical power supply component is disposed in the first airflow path and the second airflow path.
10. The cooling system as set forth in item 9, wherein the first heat exchanger is configured to transfer heat from the first heat load and the second heat load to the first cooling fluid.
11. The cooling system as set forth in item 1, wherein the first heat load is computing equipment and the second heat load is an electrical power supply component configured to provide electrical power to the computing equipment; wherein the third heat exchanger is a fluid-to-air heat exchanger; and further comprising a fan configured to induce airflow through the third heat exchanger to transfer heat from the electrical power supply component to the first cooling fluid.
12. The cooling system as set forth in any preceding item, wherein the first cooling fluid comprises water and the prime mover is a pump.
13. The cooling system as set forth in item 1, wherein the first cooling fluid is a two-phase refrigerant and the prime mover is a compressor.
14. The cooling system as set forth in item 1, further comprising a valve configured to control flow of the first cooling fluid through the targeted cooling path;
   and further comprising a controller configured to monitor a temperature associated with the second heat load and operate the valve to control the flow of the first cooling fluid through the targeted cooling path based at least in part on the temperature.
15. The cooling system as set forth in item 1, wherein the second heat load comprises an electrical power panel configured to provide electrical power to the first heat load;
   and optionally, wherein the electrical power panel comprises a plurality of breakers configured to selectively provide electrical power to the first heat load.

## Claims

1. A cooling system comprising:
a cooling loop including:
a first heat exchanger configured to transfer heat from a first heat load to a first cooling fluid;
a second heat exchanger configured to reject heat from the first cooling fluid; and
a prime mover configured to circulate the first cooling fluid through the cooling loop; and
a targeted cooling path including:
a third heat exchanger configured to transfer heat from a second heat load to the first cooling fluid;
wherein the targeted cooling path is plumbed in parallel with a first portion of the cooling loop; and
wherein the cooling system if configured to route at least a portion of the first cooling fluid through the targeted cooling path, bypassing the first portion of the cooling loop.

2. The cooling system as set forth in claim 1, wherein the first heat load includes computing equipment and the second heat load includes an electrical power supply component configured to provide electrical power to the computing equipment.

3. The cooling system as set forth in any preceding claim, wherein the second heat exchanger is configured to reject heat from the first heat load and the second heat load.

4. The cooling system as set forth in any preceding claim, wherein the prime mover is configured to circulate the first cooling fluid through the cooling loop and the targeted cooling path.

5. The cooling system as set forth in any preceding claim, wherein the targeted cooling path is plumbed in parallel with the first heat exchanger.

6. The cooling system as set forth in any preceding claim, wherein the third heat exchanger is plumbed in parallel with the first heat exchanger.

7. The cooling system as set forth in any preceding claim, wherein the first heat exchanger is a fluid-to-fluid heat exchanger configured to transfer heat from a second cooling fluid to the first cooling fluid; and wherein the second cooling fluid is configured to extract heat from computing equipment.

8. The cooling system as set forth in any preceding claim, wherein the first heat load is computing equipment; wherein the first heat exchanger is a fluid-to-air heat exchanger; and further comprising a first fan configured to induce airflow along a first airflow path through the first heat exchanger to transfer heat from the computing equipment to the first cooling fluid.

9. The cooling system as set forth in claim 8, wherein the second heat load is an electrical power supply component configured to provide electrical power to the computing equipment; wherein the third heat exchanger is a fluid-to-air heat exchanger; and further comprising a second fan configured to induce airflow along a second airflow path through the third heat exchanger to transfer heat from the electrical power supply component to the first cooling fluid;
and optionally, wherein the computing equipment is disposed in the first airflow path;
and optionally, wherein the electrical power supply component is disposed in the second airflow path;
and optionally, wherein the electrical power supply component is disposed in the first airflow path and the second airflow path.

10. The cooling system as set forth in claim 9, wherein the first heat exchanger is configured to transfer heat from the first heat load and the second heat load to the first cooling fluid.

11. The cooling system as set forth in claim 1, wherein the first heat load is computing equipment and the second heat load is an electrical power supply component configured to provide electrical power to the computing equipment; wherein the third heat exchanger is a fluid-to-air heat exchanger; and further comprising a fan configured to induce airflow through the third heat exchanger to transfer heat from the electrical power supply component to the first cooling fluid.

12. The cooling system as set forth in any preceding claim, wherein the first cooling fluid comprises water and the prime mover is a pump.

13. The cooling system as set forth in claim 1, wherein the first cooling fluid is a two-phase refrigerant and the prime mover is a compressor.

14. The cooling system as set forth in claim 1, further comprising a valve configured to control flow of the first cooling fluid through the targeted cooling path;
and further comprising a controller configured to monitor a temperature associated with the second heat load and operate the valve to control the flow of the first cooling fluid through the targeted cooling path based at least in part on the temperature.

15. The cooling system as set forth in claim 1, wherein the second heat load comprises an electrical power panel configured to provide electrical power to the first heat load; and optionally, wherein the electrical power panel comprises a plurality of breakers configured to selectively provide electrical power to the first heat load.
